Europäisches Patentamt

European Patent Office

Office européen des brevets

(19)

(11) Veröffentlichungsnummer: **0 009 225**
**B1**

(12) **EUROPÄISCHE PATENTSCHRIFT**

(45) Veröffentlichungstag der Patentschrift:
10.03.82

(21) Anmeldenummer: 79103456.4

(22) Anmeldetag: 14.09.79

(51) Int. Cl.³: **H 01 H 9/54**, H 02 H 9/00,
H 03 K 17/08

(54) Schutzbeschaltung.

(30) Priorität: 18.09.78 JP 113647/78

(43) Veröffentlichungstag der Anmeldung:
02.04.80 Patentblatt 80/7

(45) Bekanntmachung des Hinweises auf die Patenterteilung:
10.03.82 Patentblatt 82/10

(84) Benannte Vertragsstaaten:
DE FR IT NL SE

(56) Entgegenhaltungen:
CH-A-449 741
DE-A-2 114 146
DE-A1-2 451 477
DE-A1-2 651 492
DE-B-1 537 604
GB-A-1 110 447

(73) Patentinhaber: FUJI ELECTRIC CO. LTD., 1-1,
Tanabeshinden, Kawasaki-ku, Kawasaki 210 (JP)

(72) Erfinder: Nomura, Toshihiro, Ing., 1-13-15 Kanamori
machida-shi, Tokyo (JP)

(74) Vertreter: Mehl, Ernst, Dipl.-Ing. et al, Postfach 22 01 76,
D-8000 München 22 (DE)

Schutzbeschaltung

Die Erfindung betrifft eine Schutzbeschaltung für einen Schalter, zu dem ein erster Kondensator zur Begrenzung des Spannungsanstiegs über eine erste Diode parallelgeschaltet ist und zu dem eine Drossel zur Begrenzung des Stromanstiegs in Serie geschaltet ist, wobei die Drossel von der Reihenschaltung zweier Dioden, zwischen denen ein zweiter Kondensator liegt, überbrückt ist.

Eine derartige Schaltungsanordnung ist aus der DE-A1-2 651 492, insbesondere Figur 25c mit zugehöriger Beschreibung bekannt. Dabei ist ein Schalttransistor als Schalter in einem Sperrwandler eingesetzt. Dem Schalttransistor ist eine Drossel zur Begrenzung des Stromanstiegs in Serie und ein Netzwerk zur Begrenzung des Spannungsanstiegs parallelgeschaltet. Dieses Netzwerk wird als Einrichtung ohne prinzipbedingte Verluste zur Entlastung des Einwegschalters von seiner Verlustleistungsbeanspruchung beim Ausschalten bezeichnet. Es enthält eine Reihenschaltung einer Diode und eines Kondensators, die parallel zum Schalttransistor liegt. Außerdem ist zwischen dem Anschlußpunkt der Diode am Schalttransistor und dem Anschlußpunkt der Diode am Kondensator die Reihenschaltung eines zweiten Kondensators, einer zweiten Diode und einer zweiten Drossel angeordnet. Die Drossel zur Begrenzung des Stromanstiegs ist über zwei weitere Dioden mit einem dritten Kondensator verbunden. Dabei sind die weiteren Dioden gegensinnig gepolt, so daß kein Stromfluß im Kreis dieser Drossel, der weiteren Diode und des dritten Kondensators möglich ist. Der dritte Kondensator wird durch das geschilderte Netzwerk aufgeladen. Diese bekannte Schutzbeschaltung enthält eine Vielzahl von Bauelementen und ist daher sehr aufwendig.

Bei einer ebenfalls aus der genannten DE-A1-2 651 492 bekannten Schutzbeschaltung für Schalttransistoren ist einer Drossel zur Begrenzung des Stromanstiegs über eine Diode ein Kondensator parallelgeschaltet. Der Kondensator ist mit dem Eingang eines Hoch-Tiefsetzstellers verbunden, der ausgangsseitig in die Versorgungsspannungsquelle zurückspeist. Eine derartige Rückspeisung in die Versorgungsspannungsquelle ist jedoch nur dann möglich, wenn die Parallelschaltung der strombegrenzenden Drossel und des Kondensators direkt an der Versorgungsspannungsquelle liegt.

Aufgabe der Erfindung ist es daher, eine Schutzbeschaltung der eingangs genannten Art so auszubilden, daß nur eine geringe Anzahl von Bauelementen erforderlich ist und daß die bei den Schaltvorgängen in der Schutzbeschaltung aufgenommene Energie auf beliebige Weise zurückgewonnen werden kann.

Diese Aufgabe wird erfindungsgemäß dadurch gelöst, daß eine der beiden Dioden die erste Diode ist und die beiden Dioden gleichsinnig gepolt sind und daß zur effektiven Energieausnutzung der zweite Kondensator mit einer Energie-Rückgewinnungseinrichtung verbunden ist. Durch den zweiten Kondensator mit relativ hoher Kapazität, der über Dioden der Drossel zur Strombegrenzung parallelgeschaltet ist und der mit einer Energie-Rückgewinnungseinrichtung verbunden ist, wird mit geringem Aufwand eine effektive Energie-Ausnutzung ermöglicht, sobald die am zweiten Kondensator anstehende Spannung bei der Aufladung einen vorgegebenen Wert erreicht hat. Durch diese Anordnung kann die Energie zur Begrenzung des Stromes oder der Spannung wirkungsvoll zurückgewonnen werden.

Anstelle des zweiten Kondensators kann in einer einfachen Ausführungsform ein Akkumulator verwendet sein.

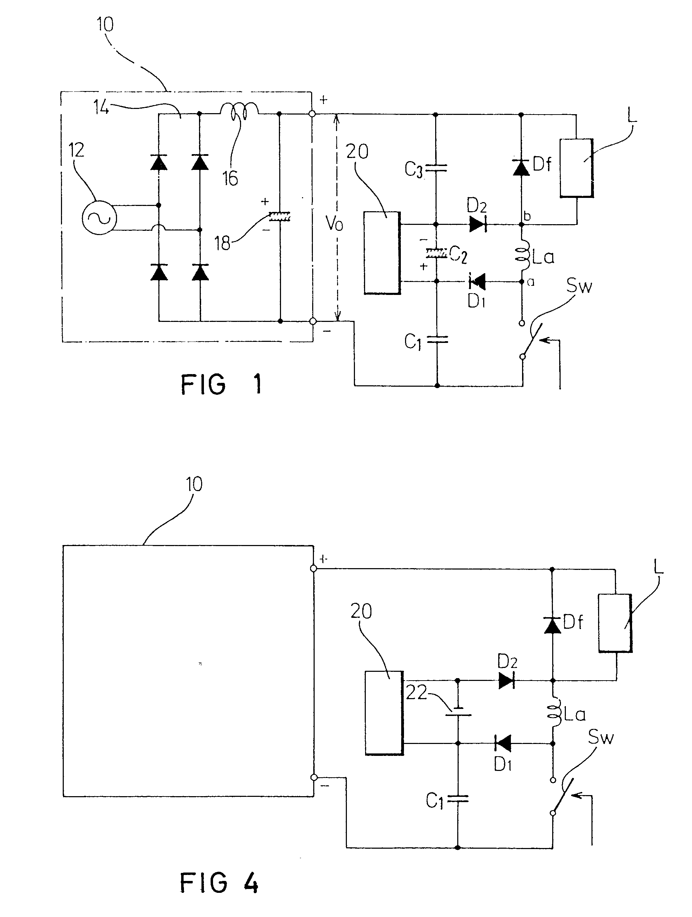

Die erfindungsgemäße Schutzbeschaltung wird nachfolgend anhand der Figuren 1 bis 5 näher erläutert. Dabei sind in den einzelnen Figuren gleiche Bauteile mit gleichen Bezugszeichen versehen.

Fig. 1 zeigt eine Gleichspannungsversorgungsquelle 10 mit einer Wechselspannungsquelle 12, einem Gleichrichter 14, einer Glättungsdrossel 16 und einem Glättungskondensator 18. Zwischen dem positiven und dem negativen Anschluß der Gleichspannungsversorgungsquelle 10 liegen in Serienschaltung eine Last L, eine Drossel La zur Strombegrenzung und ein Schalter Sw. Die Last L ist mit einer Freilaufdiode Df überbrückt. Eine Diode $D_1$, der zweite Kondensator $C_2$ und eine weitere Diode $D_2$ sind zwischen dem Verbindungspunkt a des Schalters Sw mit der Strombegrenzungsdrossel La und dem Verbindungspunkt b der Strombegrenzungsdrossel La mit der Freilaufdiode Df in Serie geschaltet. Die Dioden des so gebildeten Stromkreises weisen dieselbe Polarität auf. Als zweiter Kondensator $C_2$ kann eine billige Ausführung, z. B. ein Elektrolytkondensator verwendet werden, der eine bestimmte Polarität aufweist. Die Kapazität des zweiten Kondensators $C_2$ ist so bemessen, daß wegen der Energieaufnahme bei einem Schaltvorgang kein zu hoher Spannungsanstieg möglich ist.

Zwischen dem positiven Anschluß der Gleichspannungsversorgungsquelle 10 und der Anode der Diode $D_2$ liegt ein Kondensator $C_3$. Ein erster Kondensator $C_1$ liegt zwischen dem negativen Anschluß der Gleichspannungsversorgungsquelle und der Kathode der Diode $D_1$. Parallel zum zweiten Kondensator $C_2$ liegt eine Energie-Rückgewinnungseinrichtung 20.

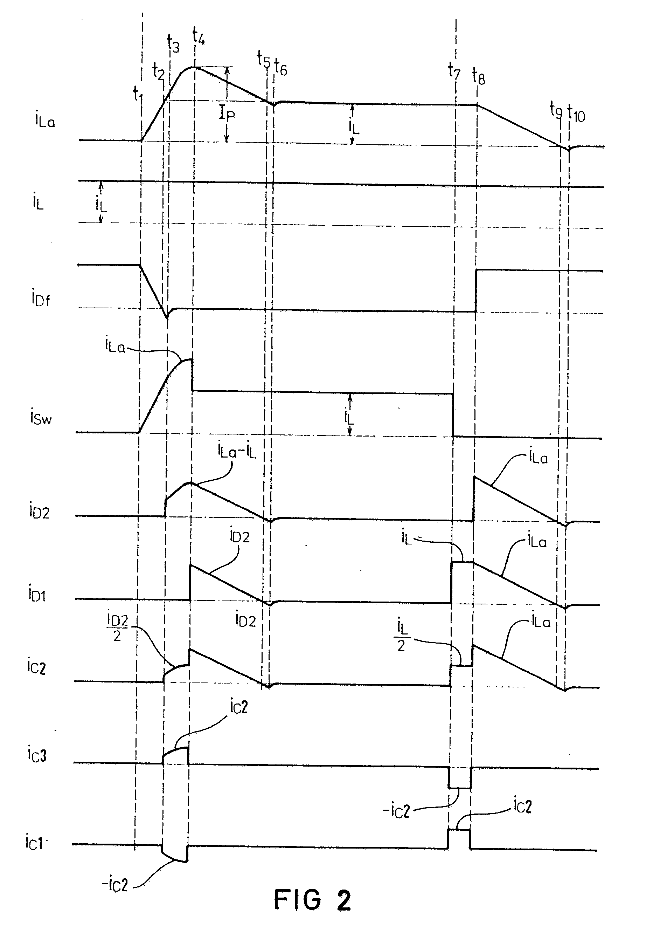

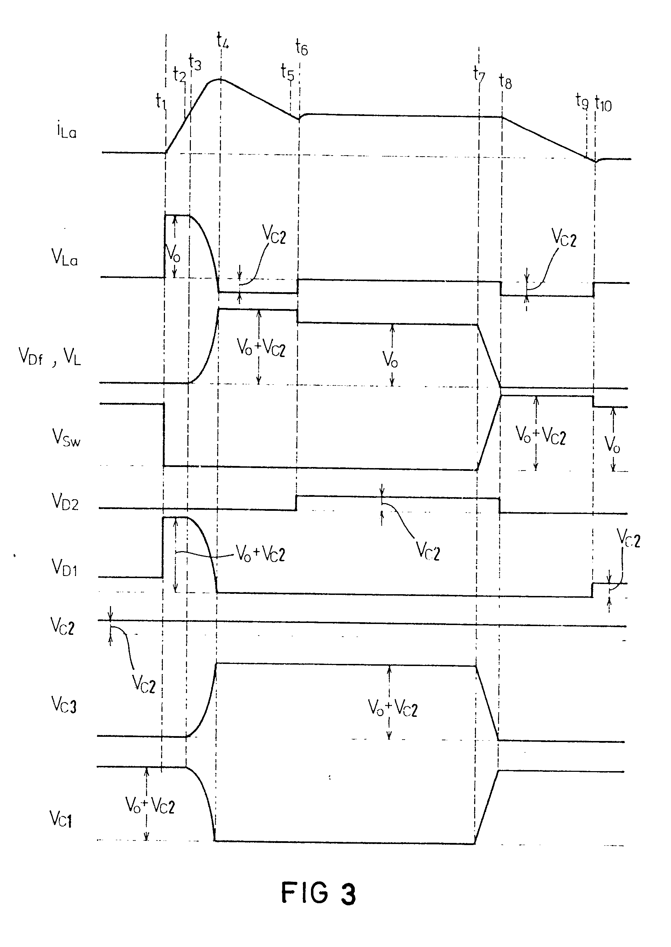

Die Funktion der dargestellten Schaltung wird im folgenden anhand der Fig. 2 und 3 erläutert. Das Diagramm nach Fig. 2 zeigt Stromverläufe in Abhängigkeit von der Zeit in verschiedenen Strompfaden der beschriebenen Schaltung beim Schließen und Öffnen des Schalters Sw. Das Diagramm nach Fig. 3 zeigt in analoger

Weise den Verlauf der Spannungen in Abhängigkeit von der Zeit. Vor dem Zeitpunkt $t_1$ ist der Schalter Sw geöffnet und der durch den induktiven Anteil der Last L hervorgerufene Strom $i_L$ fließt über die Last L und die Freilaufdiode Df.

Zum Zeitpunkt $t_1$ wird der Schalter Sw eingeschaltet und die Versorgungsgleichspannung $V_0$ liegt an der Drossel La, so daß der Strom $i_{La}$ in der Drossel La linear anzusteigen beginnt. Zum Zeitpunkt $t_2$ wird der Strom $i_{Df}$ durch die Freilaufdiode Df Null und der Strom $i_{La}$ wird gleich dem Strom $i_L$. Zu diesem Zeitpunkt $t_2$ ist die Freilaufdiode Df noch nicht im sperrenden Zustand, so daß noch etwas Strom durchfließen kann. Daher steigt der Strom $i_{La}$ durch die Drossel La weiterhin linear an, bis zum Zeitpunkt $t_3$ die Freilaufdiode sperrt. Die Stromanstiegsgeschwindigkeit $di/dt_{t1-t3}$ während der Zeit vom Zeitpunkt $t_1$ bis zum Zeitpunkt $t_3$ ist gegeben durch:

$$di/dt_{t1-t3} = V_0/L \qquad (1)$$

Dabei ist $V_0$ die Versorgungs-Gleichspannung und L die Induktivität der Drossel La. Das heißt, daß die Stromanstiegsgeschwindigkeit lediglich durch die Versorgungsgleichspannung $V_0$ und die Induktivität L vorgegeben werden kann.

Nach dem Zeitpunkt $t_3$, wenn die Freilaufdiode Df völlig sperrt, wird der Spannungsanstieg durch den Kondensator $C_3$ und die Diode $D_2$ bedämpft. Da außerdem ein geschlossener Stromkreis vom Kondensator $C_3$ durch den zweiten Kondensator $C_2$, den ersten Kondensator $C_1$ und den Glättungskondensator 18 zum Kondensator $C_3$ besteht, stehen der dritte Kondensator $C_3$ und der erste Kondensator $C_1$ miteinander in Verbindung. Die Spannungsanstiegsgeschwindigkeit $dv/dt_{t3-t4}$ vom Zeitpunkt $t_3$ bis zum Zeitpunkt $t_4$ ist gegeben durch:

$$dv/dt_{t3-t4} = i_{La}/(C_3+C_1) \qquad (2)$$

Unter der Voraussetzung, daß $C_3 = C_1$ gilt ferner:

$$dv/dt_{t3-t4} = i_{La}/2C_3 \qquad (3)$$

Die Spannung $V_{C3}$ am Kondensator $C_3$ steigt an und zum Zeitpunkt $t_4$, wenn die Spannung $V_{C1}$ gleich der Summe der Versorgungsgleichspannung $V_0$ und der Spannung $V_{C2}$ des zweiten Kondensators $C_2$ ist, kehrt die Spannung $V_{La}$ der Drossel La ihr Vorzeichen um. Der Strom $i_{La}$ durch die Drossel La beginnt dann zu fallen, während er bis zu diesem Zeitpunkt $t_4$ gestiegen ist. Während dieses Zeitraums fließt der den Laststrom $i_L$ übersteigende Anteil ($i_{La}-i_L$) des Stroms $i_{La}$ durch den geschlossenen Stromkreis mit der Drossel La, der Diode $D_1$, dem zweiten Kondensator $C_2$ und der Diode $D_2$, so daß im zweiten Kondensator $C_2$ Energie gespeichert wird. In dem erläuterten Fall ist die Abnahmegeschwindigkeit des Stroms $di/dt_{t4-t6}$ gegeben

durch:

$$di/dt_{t4-t6} = V_{C2}/L \qquad (4)$$

Dabei ist $V_{C2}$ die Spannung am zweiten Kondensator $C_2$, die annährend konstant ist und L die Induktivität der Drossel La.

Die Zeitspanne $T_{t4-t5}$ vom Zeitpunkt $t_4$ bis zum Zeitpunkt $t_5$, wenn der Drosselstrom $i_{La}$ gleich dem Laststrom $i_L$ wird, ergibt sich nach folgender Gleichung:

$$T_{t4-t5} = (I_P - i_L)/(V_{C2}/L) \qquad (5)$$

Dabei ist mit $I_P$ der Strom durch die Drossel La zum Zeitpunkt $t_4$ bezeichnet. Die Zeitdauer $T_{t4-t5}$ kann auf einfache Weise ausgelegt werden.

Zum Zeitpunkt $t_5$ sind die Dioden $D_1$ und $D_2$ noch nicht völlig im Sperrzustand, so daß für eine kurze Zeitspanne Ströme $i_{D1}$ und $i_{D2}$ in Sperrichtung fließen. Anschließend wird zu einem Zeitpunkt $t_6$ der völlige Sperrzustand erreicht und damit der Einschaltvorgang des Schalters Sw abgeschlossen. Der Kondensator $C_1$ ist zum Zeitpunkt $t_4$ völlig entladen und damit für den darauffolgenden Ausschaltvorgang vorbereitet.

Zum darauffolgenden Zeitpunkt $t_7$ wird der Schalter Sw ausgeschaltet und der Strom $i_{Sw}$ im Schalter Sw geht auf den Strom $i_{D1}$ über, der durch die Diode $D_1$ und dann parallel durch die Kondensatoren $C_1$ und $C_3$ fließt, so daß die Anstiegsgeschwindigkeit $dv/t$ der Spannung unter einem bestimmten Wert gehalten wird. Nach dem dargestellten Zeitpunkt $t_8$ beginnt ein Strom durch die Freilaufdiode Df zu fließen. Anschließend fließt bis zu einem Zeitpunkt $t_9$, bei dem der Strom $i_{La}$ durch die Drossel La Null wird, ein Strom im geschlossenen Stromkreis mit der Drossel La, der Diode $D_1$, dem zweiten Kondensator $C_2$ und der Diode $D_2$, so daß die restliche Energie der Drossel La im zweiten Kondensator $C_2$ gespeichert wird. In diesem Fall ist die Zeitdauer $T'_{t8-t9}$ vom Zeitpunkt $t_8$ bis zum Zeitpunkt $t_9$ durch eine Gleichung entsprechend Gleichung (5) gegeben. Die Zeitdauer $T'_{t8-t9}$ kann auf einfache Weise dimensioniert werden. Zum Zeitpunkt $t_9$ sind die Dioden $D_1$ und $D_2$ noch nicht völlig im Sperrzustand und folglich fließen Ströme $i_{D1}$ und $i_{D2}$ in Sperrichtung für eine kurze Zeitspanne, bis zum Zeitpunkt $t_{10}$ der völlige Sperrzustand erreicht ist und damit der Ausschaltvorgang des Schalters Sw abgeschlossen ist.

Nach dem Zeitpunkt $t_{10}$, zu dem der Ausschaltvorgang abgeschlossen ist, ist die Diode $D_1$ durch die am zweiten Kondensator $C_2$ anstehende Spannung $V_{C2}$ in Sperrichtung gepolt. Eine relativ kleine Änderung der Versorgungsgleichspannung $V_0$ kann daher die Diode $D_1$ nicht in den leitenden Zustand bringen, so daß der Schalter Sw vor Schäden durch Überströme geschützt werden kann.

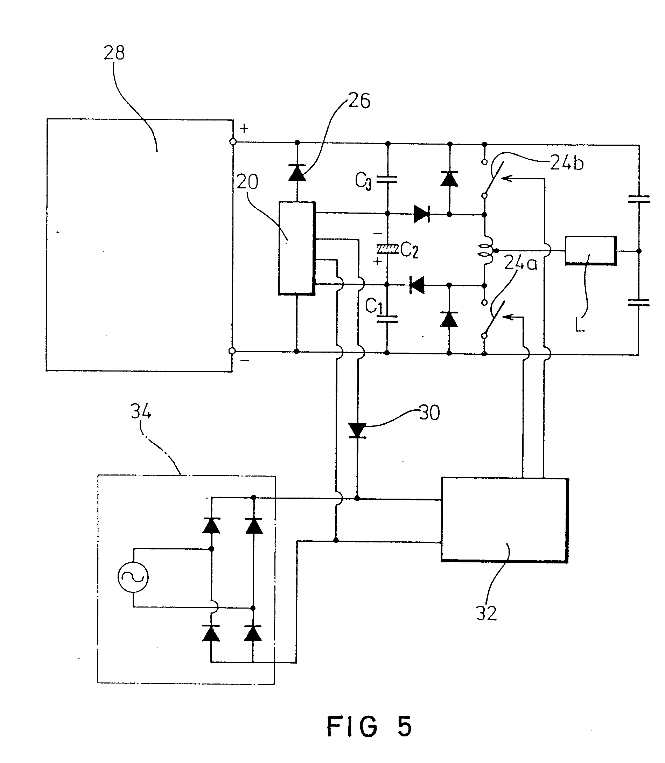

Eine Schaltung nach Fig. 4, bei der im Unterschied zur Schaltung nach Fig. 1 der

Kondensator C₃ weggelassen ist, zeigt ein ähnliches Verhalten. Ferner wird durch Ersatz des zweiten Kondensators C₂ durch einen Akkumulator 22 nach Fig. 4 ein ähnliches Verhalten erzielt.

Fig. 5 zeigt ein weiteres Ausführungsbeispiel für eine Schaltungsanordnung mit zwei Schaltern 24a und 24b. Eine Energie-Rückgewinnungseinrichtung 20 ist über eine Sperrdiode 26 an die Versorgungsspannungsquelle 28 eines Wechselrichters und über eine weitere Sperriode 30 an die Steuerspannungsquelle 34 angeschlossen. Die Steuerspannungsquelle 34 versorgt eine Steuereinrichtung 32 für die Schalter 24a und 24b. Durch eine derartige Schaltungsanordnung kann die in den zweiten Kondensator C₂ fließende oder in diesem gespeicherte Energie in die Versorgungsspannungsquelle 28 zurückgespeist werden, um den Wirkungsgrad des Systems zu verbessern. Ebenso wird es ermöglicht, daß bei einem vorübergehenden Ausfall der Versorgung durch die Steuerspannungsquelle 34 die Versorgung der Steuereinrichtung 32 zur Erhaltung der Funktionsfähigkeit aufrechterhalten wird. Eine ähnliche Schaltung, wie sie für einen Zweiphasen-Wechselrichter beschrieben wurde, kann auch für Mehrphasenwechselrichter angewendet werden.

Damit wurde also gezeigt, daß mit der beschriebenen Schaltungsanordnung durch Rückführung elektrischer Energie zur Versorgungsspannungsquelle ein zu starker Anstieg von Spannung und Strom beim Schließen und Öffnen des Schalters verhindert werden kann. Außerdem können die Betriebsbeanspruchung des Schalters verringert und Energieverluste verhindert werden. Wegen der Weglassung des Widerstands im Entladekreis kann eine geeignete Zeitdauer für die Entladung erreicht werden. Eine Beschädigung des Schalters durch Polung einer Schutzbeschaltungsdiode in Leitrichtung bei Änderung der Versorgungsspannung wird verhindert. Die Betriebskosten werden reduziert und das Funktionsverhalten wird verbessert.

Außerdem ist die beschriebene Schutzbeschaltung nicht nur für Halbleiterschalter, wie z. B. Schalttransistoren oder Thyristoren geeignet, sondern auch für mechanische Schalter, um die Betriebsbeanspruchung zu verringern.

**Patentansprüche:**

1. Schutzbeschaltung für einen Schalter (Sw), zu dem ein erster Kondensator (C₁) zur Begrenzung des Spannungsanstiegs über eine erste Diode (D₁) parallelgeschaltet ist und zu dem eine Drossel (La) zur Begrenzung des Stromanstiegs in Serie geschaltet ist, wobei die Drossel (La) von der Reihenschaltung zweier Dioden (D₁, D₂), zwischen denen ein zweiter Kondensator (C₂) liegt, überbrückt ist, dadurch gekennzeichnet, daß eine der beiden Dioden (D₁, D₂) die erste Diode ist und die beiden Dioden (D₁, D₂) gleichsinnig gepolt sind und daß zur effektiven Energieausnutzung der zweite Kondensator (C₂) mit einer Energie-Rückgewinnungseinrichtung (20) verbunden ist.

2. Schutzbeschaltung nach Anspruch 1, dadurch gekennzeichnet, daß anstelle des zweiten Kondensators (C₂) ein Akkumulator verwendet ist.

3. Schutzbeschaltung nach Anspruch 1 oder 2, dadurch gekennzeichnet, daß die Energie-Rückgewinnungseinrichtung (20) ausgangsseitig mit einer Versorgungsspannungsquelle (28) verbunden ist.

4. Schutzbeschaltung nach einem der Ansprüche 1 bis 3, dadurch gekennzeichnet, daß die Energie-Rückgewinnungseinrichtung (20) ausgangsseitig mit einer Steuerspannungsquelle (34) verbunden ist.

**Claims**

1. Protective circuit for a switch (Sw) to which a first capacitor (C₁) for limiting the voltage increase is connected in parallel via a first diode (D₁) and to which an choke (La) for limiting the current increase is connected in series, wherein the choke (La) is bridged by the series connection of two diodes (D₁, D₂) between which lies a second capacitor (C₂), characterised in that one of the two diodes (D₁, D₂) is the first diode and the two diodes (D₁, D₂) are unidirectionally poled, and that the second capacitor (C₂) is connectd to an energy-recovery device (20) in order to obtain effective utilization of energy.

2. Protective circuit as claimes in Claim 1, characterised in that an accumulator is used in place of the second capacitor (C₂).

3. Protective circuit as claimed in Claim 1 or 2, characterised in that the energy-recovery device (20) is connected at the output end to a supply voltage source (28).

4. Protective circuit as claimed in one of the Claims 1 to 3, characterised in that the energy-recovery device (20) ist connected at the output end to a control voltage source (34).

**Revendications**

1. Montage électrique de protection pour un interrupteur (Sw) sur lequel est monté en parallèle, en vue de limiter l'accroissement de la tension, et par l'intermédiare d'une première diode (D₁), un premier condensateur (C₁) et avec lequel est montée en série, en vue de limiter l'accroissement du courant, une self (La), ladite self (La) étant shuntée par un circuit série de deux diodes (D₁, D₂) entre lesquelles est situé un second condensateur (C₂), caractérisé par le fait que l'une des deux diodes (D₁, D₂) est la première diode (D₁), les deux diodes (D₁, D₂) étant polarisées dans le même sens, et par le fait que pour l'utilisation effective de l'énergie, le second condensateur (C₂) est relié à un dispositif de récupération de l'énergie (20).

2. Montage de protection selon la revendication 1, caractérisé par le fait qu'à la place du second condensateur (C₂) on utilise un accumulateur.

3. Montage de protection selon la revendication 1 ou 2, caratérisé par le fait que le dispositif de récupération de l'énergie (20) est relié par sa sortie à une source de tension d'alimentation (28).

4. Montage de protection selon l'une des revendications 1 à 3, caractérisé par le fait que le dispositif de récupération de l'énergie (20) erst relié par sa sortie à une source de tension de commande (34).

FIG 1

FIG 4

0 009 225

FIG 2

9

FIG 3

FIG 5